# EUROPEAN PATENT APPLICATION

(11) **EP 1 182 279 A1**
(43) Date of publication of application: **27.02.2002**
(21) Application number: 00307245.1
(22) Date of filing: 22.08.2000
(51) Int. Cl.: C25D 17/06, H05K 13/00, B65G 47/90, B65H 5/14

(54) **A holding device**

(71) Applicant: PROCESS AUTOMATION INTERNATIONAL LIMITED, Tai Po, New Territories (HK)
(72) Inventor: Wong, Chi Wing, New Territories, Hong Kong (CH); Tsui, Fai, Tsuen Wan, New Territories, Hong Kong (CH)
(74) Representative: Watkin, Timothy Lawrence Harvey

(57) **Abstract**

A holding device (1) comprising at least a first leg (2) pivotably connected to a lever (6) by a first securing member (22), a handle (28) from which a second leg (4) extends, and a connector (8) pivotably joined at one end (8a) with a protrusion (34) extending from said first leg member (2) and at the other end (8b) with said handle (28), wherein said lever (6) is pivotably connected to an extension (32) of said handle (6) by a securing member (18) at a fulcrum at which said lever (6) is movable from a first and second position, and wherein when said lever (6) is moved between said first position to said second position, said first leg (2) moves away from said second leg (4).

## Description

### Field of Invention

This invention relates to a device for holding an object and in particular, such a device for holding substrates to be treated in an electroplating machine.

### Background of Invention

There are a variety of devices designed for holding an object. A common design of such devices resembles a pair of scissors having a pair of members connected by a rivet usually located in the middle of the members. This rivet joins the two members together and allows them to pivot relative to each other.

There is another type of holding device in which the entire device is formed by an integral piece of material. This type of device, or clamp, is usually of "V" shape, and having a pair of legs spreading apart at an angle. When an object needs to be picked up with the clamp, the clamp is placed near the object so that it is between the legs of the clamp. A user can then pick up the object by squeezing an upper end of the clamp and cause the legs to move towards each other and hold the object.

Yet a more sophisticated holding device resembles a human hand. This type of device is usually called a robotic arm, which can perform more delicate gripping motion. Attached to an end of the robotic arm may be a plurality of artificial fingers resembling human fingers. As the artificial fingers are brought together, an object surrounded by these fingers can be lifted up. The movement of the fingers must usually be precisely co-ordinated in order to achieve a task. In fact, this type of robotic arm is usually controlled by computer algorithms.

One disadvantage of the first- and second-mentioned types of holding devices is that in a situation where an object in the form of a piece of board (e.g. a printed circuit board) is to be held, points of contact established between the members (legs or fingers) and the object are usually of small area. For instance, referring to a clamp in the form of a pair of scissors, one will be able to visualize that as the legs of the clamp are brought together towards an object, only relatively small areas of contact are established between the legs and the object. Consequently, a secure grip of the object may be difficult to achieve. This is partly due to the fact that insufficient contact surface is provided to allow adequate frictional force to be established between the legs of the clamp and the object. While the areas of contact can be increased by increasing the width (or thickness) of the leg members, a reliable grip may still be difficult to achieve as the areas of contact are still essentially limited to a line of engagement surface with each of two contact locations between each of the legs and the object.

Referring to the holding device in the form of a robotic arm, while holding an object securely and reliably may be achieved, the cost of manufacture and maintenance of such a type of device is usually extremely high as the operation of holding device relies not only on the mechanical components, but also usually a computer control system in which complicated computer hardware, software and sometimes even firmware are involved.

It is thus an object of the invention to provide a holding device in which the above shortcomings are mitigated, or at least to provide a useful alternative to the public.

### Summary of Invention

According to a first aspect of the present invention, there is provided a holding device comprising at least a first leg pivotably connected to a lever by a first securing member, a handle from which a second leg extends, and a connector pivotably joined at one a first end with a protrusion extending from said first leg and at a second end with said handle, wherein said lever is pivotably connected to an extension of said handle by a second securing member, wherein said lever is movable between a first and a second position, and wherein when said lever is moved from said first position to said second position, said first leg departs from said second leg.

According to a second aspect of the present invention, there is provided a holding device comprising at least a first leg pivotably connected to a lever by a first securing member, a handle from which a second leg extends, and a connector pivotably joined a first end with a protrusion extending substantially perpendicularly from said first leg and at a second end with said handle, wherein said lever is pivotably connected by a second securing member to an extension member which extends substantially perpendicularly from said handle, wherein said lever is movable between a first and a second position, and wherein when said lever is moved from said first position to said second position, said first leg departs away said second leg.

### Brief Description of Drawings

The invention will now be described, by way of example only, with reference to the accompanying drawings, in which:-
Fig. 1 is a side view showing a holding device according to the present invention;
Fig. 2 is the side view of the holding device shown in Fig. 1 in an alternative position;
Fig. 3 is the side view of the holding device shown in Fig. 1 in a further alternative position; and
Fig. 4 is the side view of the holding device shown in Fig. 1 in a yet further alternative position.

### Detail Description of the Preferred Embodiment

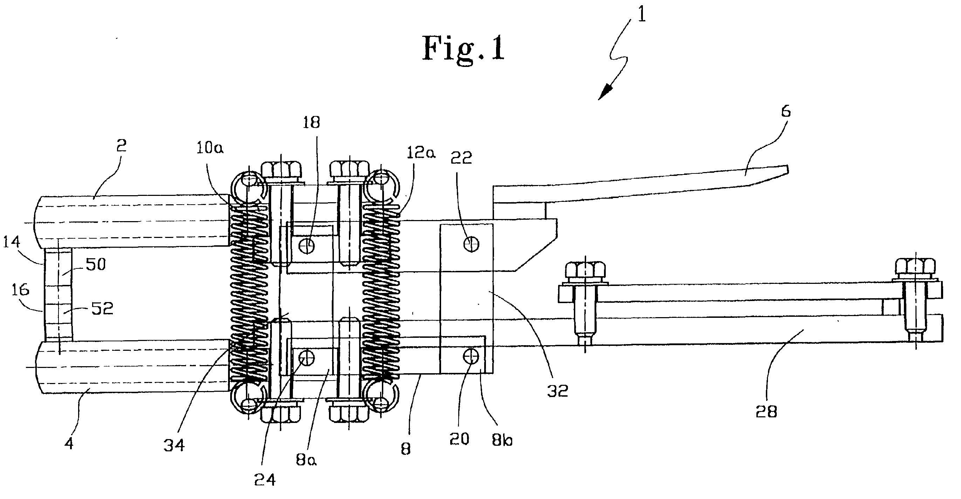

An embodiment of a holding device according to the present invention is shown in Figs. 1-4, and generally designated as 1.

Referring to Fig. 1, the holding device 1 generally includes legs 2, 4, a lever 6, a handle 28 from which the leg 4 extends and a connecting plate 8. The leg 2 is pivotably connected to the lever 6 by a rivet 18. A connecting plate 34 extending from the leg 2 is also pivotably connected to one end (as indicated by 8a in Fig. 1) of the connecting plate 8 by a rivet 24. The connecting plate 8 is connected at another end (as indicated by 8b in Fig. 1) with the handle 28 by another rivet 20. A further connecting plate 32 adjacent to the rivet 20 and extending from the handle 28 is pivotably connected to the lever 6 by a rivet 22.

There are two pairs of springs arranged on the holding device 1, namely a left frontal spring 10a, a right frontal spring 10b, a left dorsal spring 12a and a right dorsal spring 12b. The left springs 10a, 12a and the right springs 10b, 12b arranged on the two sides of the holding device 1 connect the leg 2 with the leg 4, and with the handle 28 respectively. The two pairs of springs (10a, 10b, 12a, 12b) bias the holding device 1 to the position shown in Fig. 1, which will hereafter be referred to as the "closed" position.

Arranged on an inner side of a distal end of the leg 2 is an upper lug 14. A corresponding lower lug 16 is arranged on an inner side of a distal end of the leg 4. Fig. 1 shows the holding device 1 in which the lugs 14, 16 are in contact with each other, i.e. in the closed position.

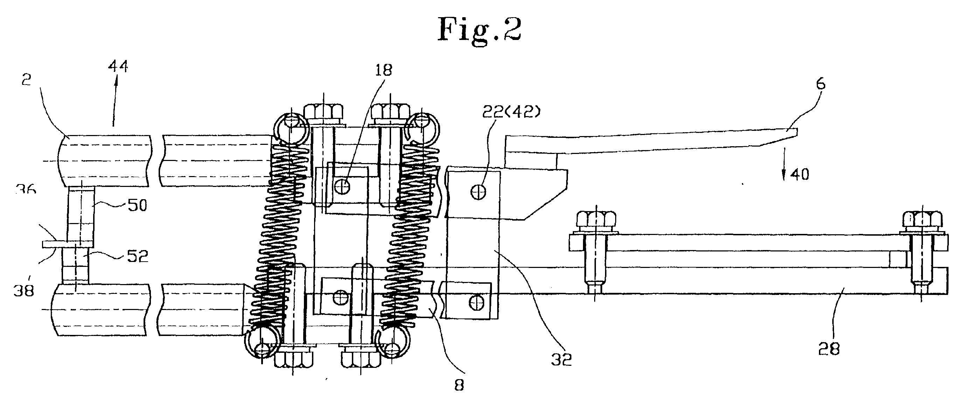

Referring to Fig. 2, the holding device 1 is in an alternative position relative to its position shown in Fig. 1. This position is achieved by moving the lever 6, e.g. by a pneumatic cylinder, relative to the handle 28 and in the direction of the arrow 40. As a result of such movement, the lever 6 moves about the rivet 22, which acts as a fulcrum 42 and consequently, the leg 2 correspondingly and pivotably moves upwards about the rivet 18, as indicated by the arrow 44. The upward movement of the leg 2 in turn lifts the connecting plate 8, which is pivotably connected to the handle 28. As a result, the connecting plate 8 pivots about the end 8b of the connecting plate 8 relative to the handle 28.

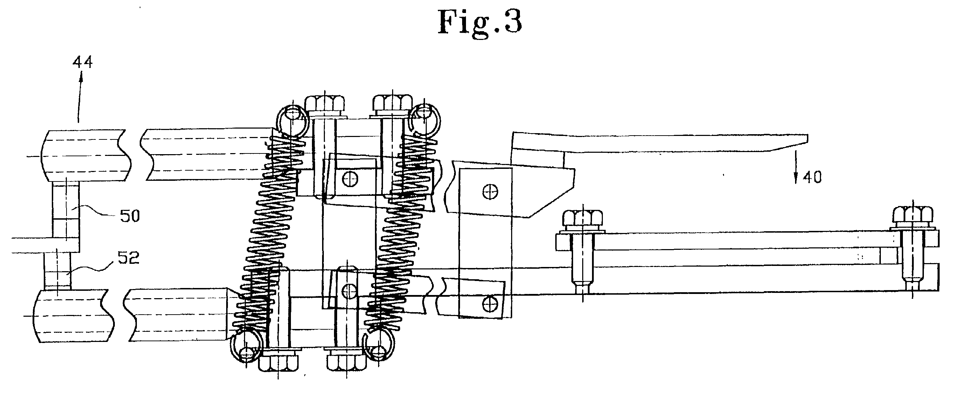

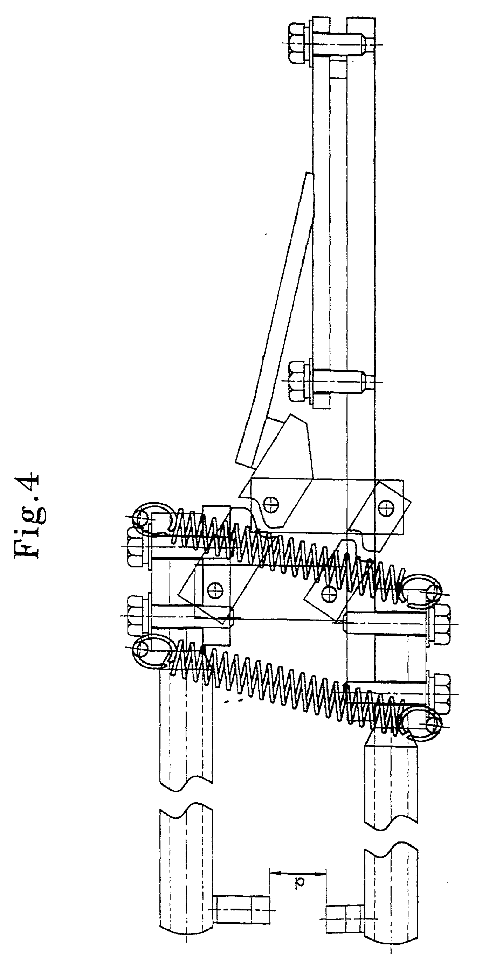

Referring to Fig. 3, as the lever 6 is further moved closer to the handle 28, the leg 2 moves further away from the leg 4. Fig. 4 shows the holding device 1 having the lever 6 lowered to a position closest to the handle 28. This position will be referred to as the 'fully-open' position hereinafter.

As shown in Figs. 2-4, as the leg 2 moves away from the leg 4, the leg 2 and the upper lug 14 attached thereto correspondingly moves away from the lower lug 16. The movement of the upper lug 14 in relation to the lower lug 16 may be understood by visualizing changes of horizontal and perpendicular distances between the lugs 14, 16. When the holding device 1 is in its default position, i.e. the closed position, an alignment is established in which an axis 50 of the upper lug 14 and an axis 52 of the lower lug 16 coincide. This alignment formed by the coincidence of the axes 50, 52 is offset when the lever 6 pivots relative to the handle 28, since the upper lug 14 not only moves horizontally away from the lower lug 16, but also moves perpendicularly away from the handle 28. One characteristic of this movement is that, unlike the prior holding device mentioned, planar surfaces 36, 38 of the lugs 14, 16 remain parallel to each other as the lever 6 is moved between the "fully-open" and "closed" positions.

In the embodiment as illustrated in Figs. 1-4, the connecting plate 34 perpendicularly extends from the leg 2. The connecting plate 32 perpendicularly extends from the handle 8 in a similar manner. As the lever 6 is lowered relative to the handle 8, it can be visualized that a shape which previously defined by the rivets 18, 20, 22, 24 changes from a rectangle to a parallelogram. A holding device constructed according to the present invention allows the upper lug 14 to move away from the lower lug 16 and yet a parallel relationship between the surfaces 36, 38 thereof is always maintained. Another characteristic is that the distances between the rivets 18 and 24, the rivets 24 and 20, the rivets 20 and 22, and the rivets 22 and 18 remain unchanged while the distances between the rivets 18 and 20, and the rivets 22 and 24 change as the lever 6 moves between the "fully-open" and "closed" positions. It can also be seen that irrespective of the position in which the lever 6 is in relative to the handle 28, the connecting plates 32 and 34 are always parallel to each other, and the connecting plate 8 and a line joining the rivets 18, 22 are also always parallel to each other.

Although not shown in this embodiment, a different embodiment might be designed in which the connecting plate 34 does not extend from the leg 2 and the connecting plate 32 does not perpendicularly extend from the handle 28. In such case, the position where the rivets 20, 22, 24 are secured can be adjusted so that the same effect of which the surfaces 36, 38 of the lugs 14, 16 remain parallel with each other is achieved.

In use, when an object needs to be treated, the lever 6 is pivoted towards the handle 28, and the holding device 1 is placed near the object so that the lugs 14 and 16 sandwich the object. The lever 6 is then released to return to the biased "closed" position by the springs 10a, 10b, 12a, 12b, and as a result, the object is securely gripped by the lugs 14, 16. In a situation where the object is in the form of a board, for example, a printed circuit board (PCB), the PCB engaged with the lugs 14, 16 may then be lowered into a treatment chamber. When the holding device 1 is used for such a purpose, both the lugs 14, 16 as well as the rest of the holding device 1 would then by made of an electrically conductive material so that electricity can pass to the PCB from the holding device 1 to chemicals contained in the treatment chamber.

It can be seen that, provided that the thickness of the PCB is smaller than the distance "d" shown in Fig. 4, the PCB can be securely held between the lugs 14, 16, as the whole planar surfaces 36, 38 of the two lugs 14, 16 contact a respective major surface of the PCB.

## Claims

1. A holding device comprising at least a first leg pivotably connected to a lever by a first securing member, a handle from which a second leg extends, and a connector pivotably joined at one a first end with a protrusion extending from said first leg and at a second end with said handle, wherein said lever is pivotably connected to an extension of said handle by a second securing member, wherein said lever is movable between a first and a second position, and wherein when said lever is moved from said first position to said second position, said first leg departs from said second leg.

2. A holding device as claimed in Claim 1 wherein at least one lug is arranged on an end of each of said first and second legs.

3. A holding device as claimed in Claim 2 wherein said lugs on said first and second legs are closest to each other when said lever is in its first position.

4. A holding device as claimed in Claim 2 wherein each of said lugs has a substantially planar surface which are substantially parallel to each other.

5. A holding device as claimed in Claim 4 wherein said planar surfaces of said lugs maintain a substantially parallel relationship with each other when said lever moves between said first and second positions.

6. A holding device as claimed in Claim 5 wherein an alignment between said lugs is established when said lever is in said first position.

7. A holding device as claimed Claim 6 wherein when said lever is moved from said first position to said second position, said alignment of said lugs is disengaged.

8. A holding device as claimed in Claim 7 wherein the distance between said first securing member and a first point of connection connecting said connector and said protrusion remains unchanged when said lever moves between said first and second positions.

9. A holding device as claimed in Claim 8 wherein the distance between said first point of connection and a second point of connection connecting said connector and said handle remains unchanged when said lever moves between said first and second positions.

10. A holding device as claimed in any preceding claim wherein when said lever moves between said first and second positions, said connector pivotably moves synchronously in response to movement of said lever.

11. A holding device as claimed in Claim 9 wherein said lever is biased towards said first position by at least one biasing member.

12. A holding device as claimed in Claim 10 wherein said pressing lever is adapted to be moved by a hydraulic cylinder.

13. A holding device comprising at least a first leg pivotably connected to a lever by a first securing member, a handle from which a second leg extends, and a connector pivotably joined a first end with a protrusion extending substantially perpendicularly from said first leg and at a second end with said handle, wherein said lever is pivotably connected by a second securing member to an extension member which extends substantially perpendicularly from said handle, wherein said lever is movable between a first and a second position, and wherein when said lever is moved from said first position to said second position, said first leg departs away said second leg.

14. A holding device as claimed in Claim 13 wherein the connector is substantially parallel to a line joining first and second securing members.

15. A holding device as claimed in Claim 13 wherein said protrusion and said extension member are substantially parallel to each other.

16. A holding device as claimed in Claim 13 wherein said connector, said protrusion, said extension member and a line joining said first and second securing members collectively form a rectangle when said lever is in said first position.

17. A holding device as claimed in Claim 13 wherein said connector, said protrusion, said extension member and a line joining said first and second securing members collectively form a parallelogram when said lever is not in said first position.

18. A holding device as claimed in Claim 13 wherein at least one lug is arranged on an end of each of said first and second legs.

19. A holding device as claimed in Claim 18 wherein said lugs on said first and second legs are closest to each other when said lever is in its first position.

20. A holding device as claimed in Claim 18 wherein each of said lugs has a substantially planar surface which are substantially parallel to each other.

21. A holding device as claimed in Claim 20 wherein said planar surfaces of said lugs maintain a substantially parallel relationship with each other when said lever moves between said first and second positions.

22. A holding device as claimed in Claim 21 wherein an alignment between said lugs is established when said lever is in said first position.

23. A holding device as claimed Claim 22 wherein when said lever is moved from said first position to said second position, said alignment of said lugs is disengaged.

24. A holding device as claimed in Claim 23 wherein the distance between said first securing member and a first point of connection connecting said connector and said protrusion remains unchanged when said lever moves between said first and second positions.

25. A holding device as claimed in Claim 24 wherein a second distance between said point of connection and a second point of connection connecting said connector and said handle remains unchanged when said lever moves between said first and second positions.

26. A holding device as claimed in any preceding claim wherein when said lever moves between said first and second positions, said connector pivotably moves synchronously in response to movement of said lever.

27. A holding device as claimed in Claim 25 wherein said lever is biased towards said first position by at least one biasing member.

28. A holding device as claimed in Claim 25 wherein said lever is adapted to be moved by a hydraulic cylinder.
